# EUROPEAN PATENT APPLICATION

(11) **EP 4 418 521 A1**
(43) Date of publication of application: **21.08.2024**
(21) Application number: 23773452.0
(22) Date of filing: 31.01.2023
(51) Int. Cl.: H02M 7/42, H05K 7/20, H05K 5/02

(54) **INVERTER AND INVERTER SYSTEM**

(30) Priority: 25.03.2022 CN 202220682108 U
(71) Applicant: Sungrow Power Supply Co., Ltd., Hefei, Anhui 230088 (CN)
(72) Inventor: WU, Fei, Hefei, Anhui 230088 (CN); WANG, Xiaohu, Hefei, Anhui 230088 (CN); ZHU, Qiyao, Hefei, Anhui 230088 (CN); DING, Jie, Hefei, Anhui 230088 (CN)
(74) Representative: Rooney, John-Paul
(86) International application number: PCT/CN2023/073931
(87) International publication number: WO 2023/179200

(57) **Abstract**

An inverter and an inverter system. The inverter comprises an inverter module and a power distribution unit; the inverter module has a first direction and a second direction which are perpendicular to each other; the inverter module is provided with a direct current input end and an alternating current output end, and the direct current input end and the alternating current output end are distributed on two sides of the inverter module in the first direction; the power distribution unit comprises a direct current module and an alternating current module, and the direct current module and the alternating current module are provided at a same end of the inverter module in the second direction; the direct current input end faces the power distribution unit; the alternating current output end faces the power distribution unit; the direct current module is electrically connected to the direct current input end; the alternating current module is electrically connected to the alternating current output end. According to the technical solution of the present utility model, the cable consumption of the inverter can be reduced, and the operation safety and maintainability of the inverter are improved.

## Description

The present application claims priority to Chinese Patent Application No. 202220682108.3, titled "INVERTER AND INVERTER SYSTEM", filed on March 25, 2022 with the China National Intellectual Property Administration, which is incorporated herein by reference in its entirety.

### FIELD

The present disclosure relates to the technical field of invertion devices, and in particular to an inverter and an inverter system.

### BACKGROUND

At present, an inverter of a photovoltaic system mainly includes a central inverter and a string inverter. For large ground power stations, the string inverter has apparent advantages in the optimization of MPPT, but distributed arrangement thereof has the disadvantages of inconvenient installation and maintenance, long cable paths and high losses.

### SUMMARY

An inverter and an inverter system are provided, to reduce the cable consumption of the inverter, and to improve the operation safety and maintainability of the inverter.

In order to achieve the above purpose, an inverter is provided according to the present disclosure. The inverter includes:
an inverting module configured with a direct-current input terminal and an alternating-current output terminal, where the direct-current input terminal and the alternating-current output terminal are respectively arranged on sides of the inverting module along a first direction; and
a power distribution unit including a direct-current module and an alternating-current module, where the direct-current module and the alternating-current module are arranged at a same side of the inverting module along a second direction, wherein the second direction is perpendicular to the first direction,
wherein both the direct-current input terminal and the alternating-current output terminal face to the power distribution unit, the direct-current module is electrically connected to the direct-current input terminal and the alternating-current module is electrically connected to the alternating-current output terminal.

In an embodiment, both the direct-current input terminal and the alternating-current output terminal face to the power distribution unit.

In an embodiment, the direct-current module includes a direct-current switch and a direct-current collector, and the alternating-current module includes an alternating-current switch and an alternating-current collector.

The direct-current switch is electrically connected with the direct-current input terminal through the direct-current collector, and the alternating-current output terminal is electrically connected with the alternating-current collector through the alternating-current switch.

In an embodiment, the direct-current module further includes a direct-current combiner cabinet and the alternating-current module further includes an alternating-current combiner cabinet;
the direct-current combiner cabinet and the alternating-current combiner cabinet are arranged next to each other along the first direction, the direct-current combiner cabinet is arranged on a side on which the alternating-current output terminal is arranged, and the alternating-current combiner cabinet is arranged on a side on which the direct-current input terminal is arranged;
the direct-current switch and the alternating-current switch are arranged separately within the direct-current combiner cabinet, and the direct-current collector and the alternating-current collector are arranged separately within the alternating-current combiner cabinet.

In an embodiment, the direct-current collector and the alternating-current collector are sequentially arranged along the second direction, and the alternating-current collector is on a side of the direct-current collector away from the inverting module.

In an embodiment, the direct-current switch and the alternating-current switch are arranged along a third direction, wherein the third direction is perpendicular to the first direction and the second direction.

In order to achieve the above purpose, an inverter system is provided according to the present disclosure. The inverter system includes a base and at least two inverters described above, where the at least two inverters are arranged on the base along the third direction, and the third direction is perpendicular to the first direction and perpendicular to the second direction.

In an embodiment, the inverter system includes the at least two inverters arranged in two rows, the inverters in the two rows are symmetrically arranged and spaced apart, the direct-current input terminal in a first row of the two rows faces to the direct-current input terminal in a second row of the two rows, and the alternating-current output terminal in the first row of the two rows is opposite to the alternating-current output terminal in the second row of the two rows.

In an embodiment, the inverting module is slidably connected to the base, such that the inverting module is detachable relative to the base.

In an embodiment, a guideway is provided on the base, a sliding block is provided on the inverting module, and the inverting module is slidably connected to the guideway through the sliding block.

In an embodiment, a limit stop is arranged at an end of the guideway, and the inverting module is located on the base by connecting the sliding block against the limit stop.

In an embodiment, the inverting module includes a first end and a second end along the second direction, and the first end is closer to the power distribution unit than the second end;
a first heat dissipation duct is arranged in the base, where air in the first heat dissipation duct flows along a path, wherein the path includes: flowing in the base through the first end in the first direction and flowing out the base through the second end in the second direction.

In an embodiment, a second heat dissipation duct is arranged in the base, air in the second heat dissipation duct flows in the first direction and/or the third direction, and the second heat dissipation duct is provided for heat dissipation of the power distribution unit.

In an embodiment, the air in the second heat dissipation duct flows through the base in the first direction or the third direction, or
the air in the second heat dissipation duct flows along the first direction and the third direction to form a circulation; where a heat exchanger is provided on the base, the heat exchanger includes a cold end arranged within the second heat dissipation duct and a hot end arranged outside the base.

In the technical solution of the present disclosure, the direct-current module and the alternating-current module of the power distribution unit are placed at the same end of the inverting module, to make the inverter have a compact structure. In addition, by setting both the direct-current input terminal and alternating-current output terminal of the inverting module facing the power distribution unit, a direct-current connection cable between the inverting module and the direct-current module and an alternating-current connection cable between the inverting module and the alternating-current module are vertically arranged, thereby reducing the cable consumption due to the cable bending, so as to reduce the cable consumption of the inverter. The reduced bending radius of cables can further reduce the distance between the inverting module and the power distribution unit, lowering the center of gravity of the inverting module when is installed, thus improving the safety and maintainability of staff operations.

### BRIEF DESCRIPTION OF THE DRAWINGS

In order to explain the solutions of the present disclosure or the technical solutions in the conventional technology more clearly, the drawings needed to be used in the description of the embodiments or the conventional technology are briefly introduced below. Apparently, the drawings in the following description are only some embodiments of the present disclosure. For those skilled in the art, other drawings can be obtained based on the structures shown in these drawings without creative efforts.
Figure 1 is a schematic structural diagram of an inverter system according to an embodiment of the present disclosure;
Figure 2 is a schematic structural diagram of an inverter system according to another embodiment of the present disclosure;
Figure 3 is a schematic structural diagram of an inverter of the inverter system in Figure 1;
Figure 4 is a schematic structural diagram of the inverter of the inverter system in Figure 1 from another perspective;
Figure 5 is a schematic structural diagram illustrating the sliding connection between a base and an inverter of the inverter system in Figure 1;
Figure 6 is a schematic structural diagram illustrating the sliding connection between the base and the inverter of the inverter system in Figure 1 from another perspective;
Figure 7 is a schematic structural diagram of a first heat dissipation duct of the inverter system in Figure 1; and
Figure 8 is a schematic structural diagram of a second heat dissipation duct of the inverter system in Figure 1.

Reference numerals are listed as follows:

| Numeral | Name | Numeral | Name |
|---|---|---|---|
| 100 | Inverter system | 132 | Alternating-current switch |
| 10 | Inverter | 133 | Alternating-current collector |
| 11 | Inverting module | 134 | Alternating-current connection cable |
| 111 | Direct-current input terminal | 14 | Sliding block |
| 112 | Alternating-current output terminal | 50 | Base |
| 12 | Direct-current module | 51 | Platform |
| 121 | Direct-current combiner cabinet | 52 | Support frame |
| 122 | Direct-current switch | 53 | Guideway |
| 123 | Direct-current collector | 54 | Limit stop |
| 124 | Direct-current connection cable | 55 | First heat dissipation duct |
| 125 | Direct-current input cable | 56 | Second heat dissipation duct |
| 13 | Alternating-current module | 57 | Heat exchanger |
| 131 | Alternating-current combiner cabinet | | |

### DETAILED DESCRIPTION

The technical solutions according to the embodiments of the present disclosure will be described clearly and completely as follows in conjunction with the drawings in the embodiments of the present disclosure. It is apparent that the described embodiments are only part of the embodiments according to the present disclosure, rather than all of the embodiments. Based on the embodiments of the present disclosure, all other embodiments obtained by those skilled in the art without creative work shall fall within the protection scope of the present disclosure.

It should be noted that, all directional indicators (such as up, down, left, right, front, back......) in the embodiment of the present disclosure are only used for explaining a relative position relationship and movement situation among components in a certain specific posture (as shown in the drawings). If the specific posture changes, the directional indicators will change accordingly.

In addition, in the present disclosure, the terms, such as "first" and "second", are only used for descriptive purposes, and should not be understood as indicating or implying the relative importance or implicitly indicating the number of indicated technical features. Therefore, the features defined with "first", "second" may include at least one of the features explicitly or implicitly. In addition, the technical solutions between the various embodiments can be combined with each other, but they must be based on the realization by those skilled in the art. When the combination of technical solutions is contradictory or cannot be realized, it should be considered that such a combination of technical solutions does not exist, and is not within the protection scope of the present disclosure.

An inverter 10 is provided according to the present disclosure.

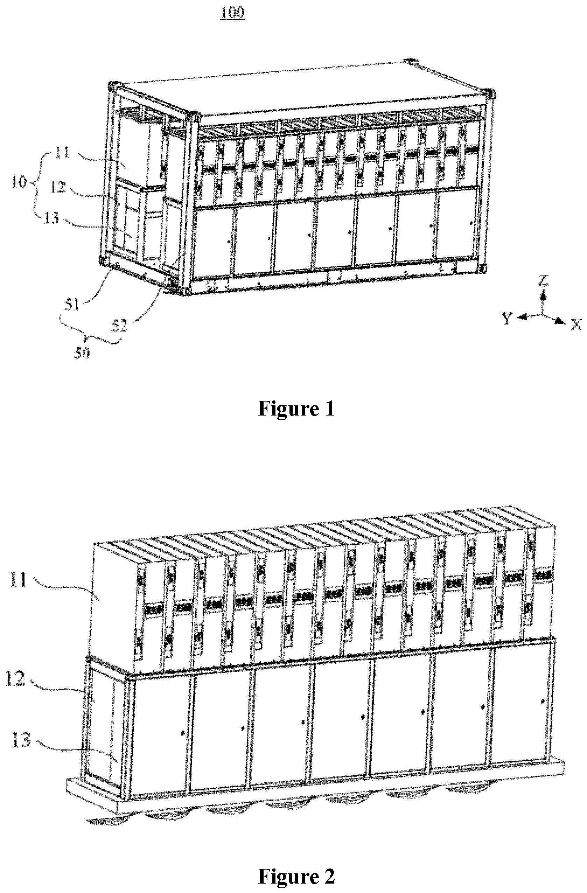

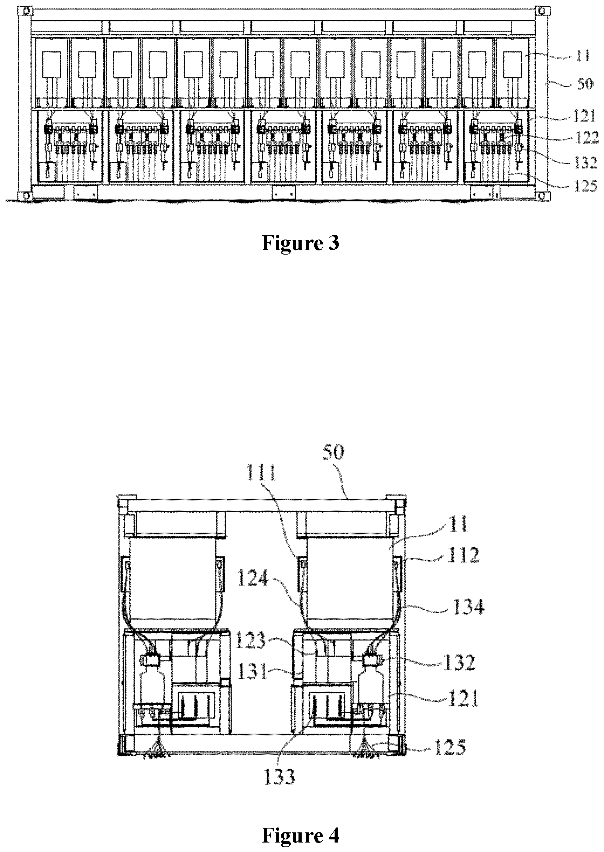

In an embodiment of the present disclosure, as shown in Figure 1 and Figure 4, the inverter 10 includes an inverting module 11 and a power distribution unit. A first direction and a second direction perpendicular to the first direction are set for the inverting module 11. The inverting module 11 is configured with a direct-current input terminal 111 and an alternating-current output terminal 112. The direct-current input terminal 111 and the alternating-current output terminal 112 are respectively arranged on both side of the inverting module along the first direction. The power distribution unit includes a direct-current module 12 and an alternating-current module 13. The direct-current module 12 and the alternating-current module 13 are arranged at the same side of the inverting module 11 along the second direction. The direct-current input terminal 111 and the alternating-current output terminal 112 both face to the power distribution unit. The direct-current module 12 is electrically connected to the direct-current input terminal 111, and the alternating-current module 13 is electrically connected to the alternating-current output terminal 112.

It should be noted that in Figure 1, X direction is the first direction, Z direction is the second direction, and Y direction is a third direction. The following description of directions and coordinates may refer to Figure 1. For the convenience of description, the first direction is illustrated as a front-rear direction, the second direction is illustrated as an up-down direction, and the third direction is illustrated as a left-right direction.

Specifically, the inverter 10 including an inverting module 11 and a power distribution unit is configured with a two-layer structure. The inverting module 11 is placed on the upper layer. The power distribution unit, namely, the direct-current module 12 and the alternating-current module 13, is placed on the lower layer. An input terminal of the direct-current module 12 is connected to an external direct-current device, such as a combiner cabinet, energy storage device, etc., and an output terminal of the direct-current module 12 is connected to the direct-current input terminal 111 of the inverting module 11. An input terminal of the alternating-current module 13 is connected to the alternating-current output terminal 112 of the inverting module 11, and an output terminal of the alternating-current module 13 is connected to an external load or transformer. The inverting module 11 is configured to convert the input direct current into the alternating current. Through the above arrangement, the direct-current power from an external direct-current device can be converted into alternating-current power and output to an external load.

In the embodiment, the direct-current module 12 and the alternating-current module 13 of the power distribution unit are placed at the same side of the inverting module 11, to make the inverter 10 have a compact structure. In addition, both the direct-current input terminal 111 and the alternating-current output terminal 112 of the inverting module 11 are set facing the power distribution unit, in another word, the direct-current output terminal and the alternating-current output terminal 112 are arranged in the up-down direction (the second direction) rather than in the horizontal direct (the first direction). Thus, in the inverter, the direct-current connection cable between the inverting module 11 and the direct-current module 12 and the alternating-current connection cable between the inverting module 11 and the alternating-current module 13 are vertically arranged, thereby reducing the cable consumption due to the cable bending, so as to reduce the cable consumption of the inverter 10. The reduced bending radius of cables can further reduce the distance between the inverting module 11 and the power distribution unit, lowering the center of gravity of the inverting module 11 when is installed, thus improving the safety and maintainability of staff operations.

In an embodiment, as shown in Figure 3 and Figure 4, the direct-current module 12 includes a direct-current switch 122 and a direct-current collector 123. The alternating-current module 13 includes an alternating-current switch 132 and an alternating-current collector 133. The direct-current switch 122 is electrically connected with the direct-current input terminal 111 through the direct-current collector 123, and the alternating-current output terminal 112 is electrically connected with the alternating-current collector 133 through the alternating-current switch 132.

In an embodiment, the input terminal of the direct-current module 12 is the direct-current switch 122, the output terminal of the direct-current module 12 is the direct-current collector 123, and the direct-current switch 122 is connected with the direct-current collector 123. In addition, the direct-current module 12 further includes a direct-current connection cable 124. The direct-current collector 12 is connected to the direct-current input terminal 111 of the inverting module 11 by the direct-current connection cable 124. The input terminal of the alternating-current module 13 is the alternating-current switch 132, and the output terminal of the alternating-current module 13 is the alternating-current collector 133. The alternating-current switch 132 is connected to the alternating-current collector 133. In addition, the alternating-current module 13 further includes an alternating-current connection cable 134. The alternating-current switch 132 is connected to the alternating-current output terminal 112 of the inverting module 11 by the alternating-current connection cable 134. In addition, the external direct-current device is connected to the direct-current switch 122 through a direct-current input cable.

The direct-current switch 122 may be a breaker/load switch. The alternating-current switch 132 may be a fuse combination switch. The current input from the external direct-current device passes through the direct-current breaker/load switch in the direct-current module 12, is connected in series with the direct-current collector 123 (copper bar), and then enters the direct-current input terminal 111 of the inverting module 11. The current is output from the alternating-current output terminal 112 of the inverting module 11 to the fuse combination switch of the alternating-current module 13, and finally enters the alternating-current combiner cabinet 131 to converge through the alternating-current collector 133 (copper bar).

Through the vertical connection between the inverting module 11 and the direct-current module 12 and the vertical connection between the inverting module 11 and the alternating-current module 13, the cable consumption due to the bending of the direct-current connection cable 124 and the alternating-current connection cable 134 can be reduced, such that the total cable consumption of the inverting module 11 is reduced. The bending radii of the direct-current connection cable 124 and the alternating-current connection cable 134 are reduced, which can further reduce the distance between the inverting module 11 and the power distribution unit and reduce the center of gravity of the inverting module 11 when is installed, thereby improving the safety and maintainability of staff operations.

In an embodiment, as shown in Figure 3 and Figure 4, the direct-current module 12 further includes a direct-current combiner cabinet 121, and the alternating-current module 13 further includes an alternating-current combiner cabinet 131. The direct-current combiner cabinet 121 and the alternating-current combiner cabinet 131 are arranged next to each other along the first direction, the direct-current combiner cabinet 121 is arranged on a side on which the alternating-current output terminal 112 is arranged. The alternating-current combiner cabinet 131 is arranged on a side on which the direct-current input terminal 111 is arranged. The direct-current switch 122 and the alternating-current switch 132 are arranged separately within the direct-current combiner cabinet 121. The direct-current collector 123 and the alternating-current collector 133 are arranged separately within the alternating-current combiner cabinet 131.

In an embodiment, the direct-current combiner cabinet 121 and the alternating-current combiner cabinet 131 are arranged next to each other along the front-rear direction. The alternating-current module 13 is arranged above the direct-current combiner cabinet 121 and the alternating-current combiner cabinet 131. A movable door which can be opened is provided on a side of the direct-current combiner cabinet 121 away from the alternating-current combiner cabinet 131, which is used to cover or expose the direct-current combiner cabinet 121. By installing the direct-current switch 122 and the alternating-current switch 132 in the direct-current combiner cabinet 121, it is convenient for the staff to directly operate the switching device on a side, on which the direct-current combiner cabinet 121 is arranged, of the inverter 10. In this way, the safety and maintainability of the staff operations are improved.

In an embodiment, as shown in Figure 4, the direct-current collector 123 and the alternating-current collector 133 are arranged along the second direction. The alternating-current collector 133 is on a side of the direct-current collector 123 away from the inverting module 11.

In an embodiment, the direct-current collector 123 is arranged at the rear of the direct-current combiner cabinet 121 and in an upper space of the alternating-current combiner cabinet 131. That is, the direct-current collector 123 and the alternating-current collector are both arranged in the alternating-current combiner cabinet 131, and the direct-current collector 123 is above the alternating-current collector. In order to prevent the direct-current collector 123 and the alternating-current collector from interfering with each other, a spacer plate is installed therebetween. Correspondingly, the direct-current switch 122 is positioned slightly higher than the alternating-current switch 132. The alternating-current switch 132 (fuse combination switch) has an input terminal on the top of the alternating-current switch 132 and an output terminal at the bottom of the alternating-current switch 132. Thus, the alternating-current combiner cabinet 131 is arranged behind the direct-current combiner cabinet 121, the cable connected to the output terminal of the fuse combination switch enters the alternating-current combiner cabinet 131 and is directly connected to the alternating-current collector 133. In this way, the cable has the shortest path, while the intersection of the alternating-current path and the direct-current path is avoided. In addition, the direct-current input terminal 111 of the inverting module 11 is arranged on the rear side of the inverting module 11; and the alternating-current output terminal 112 of the inverting module 11 is arranged on the front side of the inverting module 11. This arrangement can match the device which provided below the inverting module 11, so that the inverting module 11 has the shortest connection paths to the output terminal of the direct-current module 12 and to the input terminal of the alternating-current module 13.

In an embodiment, as shown in Figure 3, the direct-current switch 122 and the alternating-current switch 132 are arranged along a third direction. The third direction is perpendicular to the first direction and the second direction.

In an embodiment, the direct-current module 12 includes two direct-current switches 122, and the alternating-current module 13 includes two alternating-current switches 132. The two direct-current switches 132 are arranged in the middle, and the two alternating-current switches 132 are arranged at the left side and the right side of the direct-current switches. In this way, the alternating-current switches 132 and the direct-current switches 122 can be staggered to avoid cross-wiring

An inverter system 100 is further provided by the present disclosure. The inverter system includes a base 50 and at least two inverters 10. The structure of the inverters can be referred to the embodiments above. Since the inverter system 100 adopts all the technical solutions of the above embodiments, it has at least all the beneficial effects brought by the technical solutions of the above embodiments, which will not be repeated herein. At least two inverters 10 are arranged on the base 50 along the third direction, where the third direction is perpendicular to the first direction and the second direction.

Specifically, the base 50 includes a platform 51 arranged at the bottom and a support frame 52 connected to the platform 51. The platform 51 is used to carry multiple inverters 10, and the support frame 52 forms multiple structural spaces for installing the multiple inverters 10 on the platform 51. In addition, the support frame 52 can be enclosed by panels, to form a relatively closed space inside the base 50. The inverters 10 can be protected by the relatively closed space, to meet the requirements of the inverter 10 for different IP levels (protection levels including dustproof and waterproof etc.).

In an embodiment, as shown in Figure 1, the inverters 10 are provided in two rows. The inverters in the two rows are symmetrically arranged and spaced apart. The direct-current input terminals 111 in one of the two rows faces to the direct-current input terminals 111 in the other of the two rows, and the alternating-current output terminals in the one of the two rows is opposite to the alternating-current output terminals in the other of the two rows.

In an embodiment, the multiple inverters 10 in one row are arranged sequentially in the left-right direction, and the two rows of inverters 10 are arranged in the front-rear direction. A gap is between the two rows of inverters 10 to reserve wiring space. In the two rows of inverters 10, the alternating-current output terminals 112 of each row of inverters 10 are arranged outside the base 50. Correspondingly, the direct-current input terminals 111 of each row of inverters 10 are arranged inside the base 50. By this arrangement, the inverter 10 can match the device layout of the power distribution unit below, to arrange the direct-current switch 122 and the alternating-current switch 132 outside the base 50. In this way, the staff can directly operate the switching devices outside the base 50, thereby improving the safety and maintainability of the staff operations. In addition, the connection path between the output terminal of the direct-current module 12 and the inverting module 11, and the connection path between the input terminal of the alternating-current module 13 and the inverting module 11 can be shortest, thereby reducing the cable consumptions.

The base 50 in this embodiment may adopt the external dimensions of a standard 20-foot container to meet transportation requirements. In order to the capacity maximization within the space size of the base 50, the two rows of inverters 10 are placed symmetrically in this embodiment, as shown in Figure 1. In actual applications, a single row of inverters 10 may also be placed on the base 50, as shown in Figure 2.

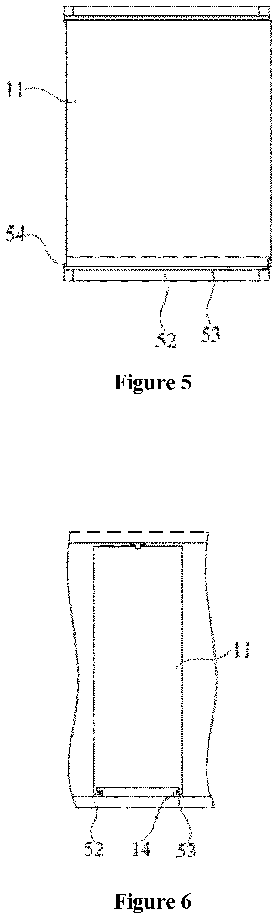

In an embodiment, as shown in Figure 5 and Figure 6, the inverting module 11 is slidably connected to the base 50, so that the inverting module 11 is detachable relative to the base 50.

In an embodiment, the base 50 includes a platform 51 and a support frame 52 connected to the platform 51. The inverting module 11 is detachably installed on the support frame 52. In an embodiment, the inverting module 11 is detachably installed on the support frame 52 by a sliding connection. In this way, the workers can quickly assemble and unassembled the inverting module 11 on the base 50, to replace and maintain the inverting module 11 on the base 50 quickly.

In an embodiment, as shown in Figure 5 and Figure 6, a guideway 53 is provided on the base 50, a sliding block 14 is provided on the inverting module 11, and the inverting module 11 is slidably connected to the guideway 53 through the sliding block 14.

In an embodiment, the inverting module 11 and the support frame 52 are slidably connected. The upper and lower surfaces of the support frame 52 matching the inverting module 11 may be provided with sliding pairs, to ensure the stability between each inverter 10 and the base 50 during transportation of the inverter system 100. In actual application, at least one sliding pair may also be arranged on the top, bottom or sides of the inverting module 11.

In an embodiment, as shown in Figure 5 and Figure 6, a limit stop 54 is arranged at an end of the guideway 53, and the sliding block 14 can be connected against the limit stop 54 to locate the inverting module 11 on the base 50.

In an embodiment, the limit stop 54 may be a stop block structure, which is arranged at an end of the guideway 53 and is a convex parts perpendicular to an extension direction of the guideway 53. When the inverter 10 is slid into a setting place along the support frame 52, the sliding block 14 on the inverter 10 will be connected against the limit stop 54 at the end of the guideway 53 to stop the inverter 10. By the above arrangement, it is ensured that the inverting module 11 will not slide out of the base 50 under normal working conditions and during transportation. The limit stops 54 may be provided on both ends of the guideway 53. It can be understood that the limit stop 54 at one end of the guideway 53 may have a fixed structure, and the limit stop 54 at the other end of the guideway 53 may have a movable structure. The movable limit stop is opened when the inverter 10 is assembled and unassembled, and is fixed when the inverter 10 is used normally.

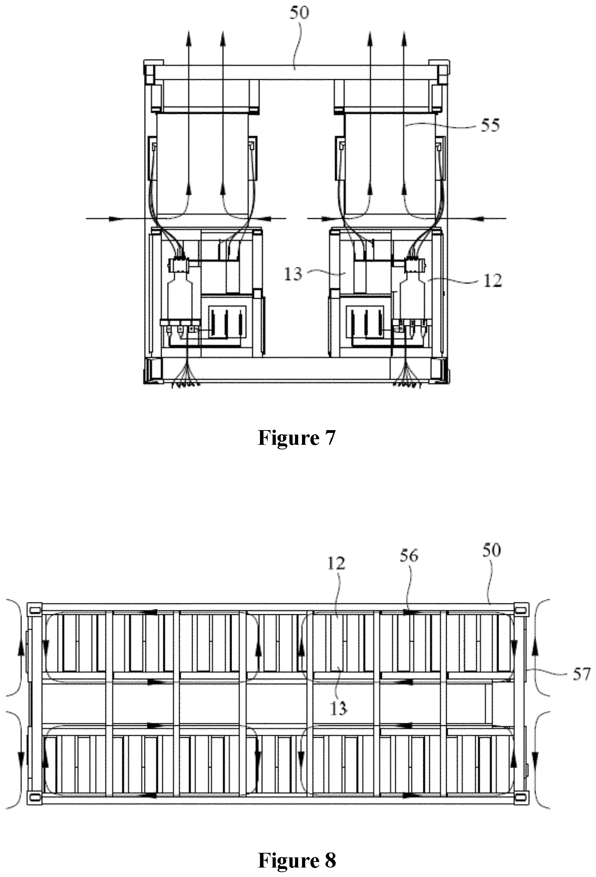

In an embodiment, as shown in Figure 7, the inverting module 11 includes a first end and a second end along the second direction, and the first end is closer to the power distribution unit than the second end. A first heat dissipation duct 55 is arranged in the base 50. Air in the first heat dissipation duct 55 flows along a path: flowing in the base 50 through the first end in the first direction and flowing out of the base 50 through the second end in the second direction.

In an embodiment, the base 50 includes a platform 51 and a support frame 52 connected to the platform 51. The support frame 52 may be enclosed by panels, to form a relatively closed space inside the base 50 to protect the inverter 10. In this case, the inverter 10 needs to be cooled. In this embodiment, a heat dissipation structure includes a first heat dissipation duct 55 for cooling an individual inverting module 11. The first heat dissipation duct 55 may be formed by providing a baffle in the internal space of the base 50, and a first air inlet and a first air outlet of the first heat dissipation duct 55 are provided on the surface of the base 50. The first air inlet is arranged at a side of the base 50 facing the first end of the inverting module 11.The first air outlet is arranged on the top surface of the base 50 faces the second end of the inverting module 11. A first fan may be installed in the first heat dissipation duct 55 to limit the air flow direction in the first heat dissipation duct 55. In this way, the first heat dissipation duct 55 forms a bottom air inlet and top air outlet mode, which can effectively cool the inverting module 11 and avoid the thermal influence of the air outlets between adjacent inverters 10.

In an embodiment, as shown in Figure 8, a second heat dissipation duct 56 is arranged in the base 50. Air in the second heat dissipation duct 56 flows in the first direction and/or the third direction. The second heat dissipation duct 56 is provided for cooling the power distribution unit.

In this embodiment, the heat dissipation structure of the base 50 further includes a second heat dissipation duct 56 for separately cooling the power distribution unit. The second heat dissipation duct 56 accelerates the air flow around the power distribution unit, thereby effectively cooling the power distribution unit. The second heat dissipation duct 56 is arranged horizontally, while the first heat dissipation duct is arranged in a bottom-in-top-out manner. That is, in the system structural layout of this solution, two air duct spaces are arranged vertically for heat dissipation, which can minimize the coupling influence of the two heat dissipation ducts.

In an embodiment, air in the second heat dissipation duct flows through the base 50 in the first direction or the third direction.

As an implementation method, the second heat dissipation duct 56 adopts a straight ventilation manner, and a part of air inlet and air outlet is provided in a horizontal direction. That is, the second air inlet and the second air outlet of the second heat dissipation duct 56 are respectively arranged at opposite ends of the base 50. By installing a second fan in the second heat dissipation duct 56, the outside air enters the second heat dissipation duct 56 and then flows out, to effectively cool the power distribution unit. In addition, such an arrangement can prevent the hot air from the power distribution unit from affecting the heat dissipation effect of the inverting module 11.

In an embodiment, as shown in Figure 8, the air in the second heat dissipation duct flows along the first direction and the third direction to form a circulation. A heat exchanger 57 is provided on the base 50. The heat exchanger 57 includes a cold end arranged within the second heat dissipation duct 56 and a hot end arranged outside the base 50.

As an implementation method, the heat dissipation duct 56 adopts a manner of a heat exchanger 57. The second heat dissipation duct 56 forms a closed-loop air channel in the internal space of the base 50. The heat exchanger 57 is provided on the base 50, which is used for the second heat dissipation duct 56. In this way, the heat from the power distribution unit is taken away through the internal circulation and heat is exchanged by the heat exchanger 57 to transfer the heat to the outside. In an embodiment, as shown in Figure 8, the heat exchanger 57 may be installed at both ends of the base 50 along the third direction. In another embodiment, in the case that the inverter system 100 includes two rows of spaced apart inverters 10, the heat exchanger 57 may be installed at an inside of an aisle between two rows of inverters 10.

Whether the second heat dissipation duct 56 adopts the straight ventilation manner or the manner of heat exchanger 57 depends on the IP level requirements of the inverter system 100. It can be understood that the manner of heat exchanger 57 can meet the higher IP level requirements of the inverter system 100.

The above embodiments are only preferred embodiments of the present disclosure, and do not limit the scope of the present disclosure. With the inventive concept of the present disclosure, any equivalent structural transformation made by using the contents of description and drawings of the present disclosure, or direct/indirect implementation in other related technical fields, are included in the protection scope of the present disclosure.

## Claims

1. An inverter, comprising:
an inverting module configured with a direct-current input terminal and an alternating-current output terminal, wherein the direct-current input terminal and the alternating-current output terminal are respectively arranged on sides of the inverting module along a first direction; and
a power distribution unit comprising a direct-current module and an alternating-current module, wherein the direct-current module and the alternating-current module are arranged at a same side of the inverting module along a second direction, wherein the second direction is perpendicular to the first direction,
wherein both the direct-current input terminal and the alternating-current output terminal face to the power distribution unit, the direct-current module is electrically connected to the direct-current input terminal and the alternating-current module is electrically connected to the alternating-current output terminal.

2. The inverter according to claim 1, wherein the direct-current module comprises a direct-current switch and a direct-current collector, and the alternating-current module comprises an alternating-current switch and an alternating-current collector, wherein
the direct-current switch is electrically connected with the direct-current input terminal through the direct-current collector, and the alternating-current output terminal is electrically connected with the alternating-current collector through the alternating-current switch.

3. The inverter according to claim 2, wherein the direct-current module further comprises a direct-current combiner cabinet and the alternating-current module further comprises an alternating-current combiner cabinet;
the direct-current combiner cabinet and the alternating-current combiner cabinet are arranged next to each other along the first direction, the direct-current combiner cabinet is arranged on a side on which the alternating-current output terminal is arranged, and the alternating-current combiner cabinet is arranged on a side on which the direct-current input terminal is arranged;
the direct-current switch and the alternating-current switch are arranged separately within the direct-current combiner cabinet, and the direct-current collector and the alternating-current collector are arranged separately within the alternating-current combiner cabinet.

4. The inverter according to claim 3, wherein the direct-current collector and the alternating-current collector are sequentially arranged along the second direction, and the alternating-current collector is on a side of the direct-current collector away from the inverting module.

5. The inverter according to claim 4, wherein the direct-current switch and the alternating-current switch are arranged along a third direction, wherein the third direction is perpendicular to the first direction and the second direction.

6. An inverter system, comprising:
a base; and
at least two inverters according to any one of claims 1 to 5,
wherein the at least two inverters are arranged on the base along a third direction, wherein the third direction is perpendicular to the first direction and the second direction.

7. The inverter system according to claim 6, wherein the inverter system comprises the at least two inverters arranged in two rows, the inverters in the two rows are symmetrically arranged and spaced apart, the direct-current input terminal in a first row of the two rows faces to the direct-current input terminal in a second row of the two rows, and the alternating-current output terminal in the first row of the two rows is opposite to the alternating-current output terminal in the second row of the two rows.

8. The inverter system according to claim 6, wherein the inverting module is slidably connected to the base, such that the inverting module is detachable relative to the base.

9. The inverter system according to claim 8, wherein a guideway is provided on the base, a sliding block is provided on the inverting module, and the inverting module is slidably connected to the guideway through the sliding block.

10. The inverter system according to claim 9, wherein a limit stop is arranged at an end of the guideway, and the inverting module is located on the base by connecting the sliding block against the limit stop.

11. The inverter system according to claim 6, wherein the inverting module comprises a first end and a second end along the second direction, and the first end is closer to the power distribution unit than the second end;
a first heat dissipation duct is arranged in the base, wherein air in the first heat dissipation duct flows along a path, wherein the path comprises: flowing in the base through the first end in the first direction and flowing out of the base through the second end in the second direction.

12. The inverter system according to claim 6, wherein a second heat dissipation duct is arranged in the base, air in the second heat dissipation duct flows in the first direction and/or the third direction, and the second heat dissipation duct is provided for heat dissipation of the power distribution unit.

13. The inverter system according to claim 12, wherein the air in the flow direction of the second heat dissipation duct flows through the base in the first direction or the third direction, or
the air in the second heat dissipation duct flows along the first direction and the third direction to form a circulation;
wherein a heat exchanger is provided on the base, the heat exchanger comprises a cold end arranged within the second heat dissipation duct and a hot end arranged outside the base.
